# EUROPÄISCHE PATENTSCHRIFT

(11) **EP 3 942 197 B1**
(45) Veröffentlichungstag und Bekanntmachung des Hinweises auf die Patenterteilung: **06.05.2026**
(21) Anmeldenummer: 20711937.1
(22) Anmeldetag: 18.03.2020
(51) Int. Cl.: G03F 7/00, F16F 15/03, H01F 7/06, H02K 5/04, H02K 33/18, H02K 41/035, H01F 7/02, H02K 11/01, H01F 7/08

(54) **SCHWINGUNGSISOLATIONSSYSTEM MIT EINEM MAGNETAKTOR SOWIE MAGNETAKTOR**
VIBRATION INSULATION SYSTEM WITH A MAGNETIC ACTUATOR
SYSTÈME D'ISOLATION CONTRE LES VIBRATIONS DOTÉ D'UN ACTIONNEUR MAGNÉTIQUE

(30) Priorität: 19.03.2019 EP 19163715
(43) Veröffentlichungstag der Anmeldung: 26.01.2022
(73) Patentinhaber: Integrated Dynamics Engineering GmbH, 65479 Raunheim (DE)
(72) Erfinder: HARTGERS, Han, 55122 Mainz (DE); EVERS, Arndt, 65375 Oestrich-Winkel (DE); SCHADT, Simon, 65195 Wiesbaden (DE)
(74) Vertreter: Blumbach · Zinngrebe Patentanwälte PartG mbB
(86) Internationale Anmeldenummer: PCT/EP2020/057496
(87) Internationale Veröffentlichungsnummer: WO 2020/187999

(56) Entgegenhaltungen:
- WO-A2-2006/127500
- JP-A- 2007 274 820
- US-A1- 2001 040 324
- US-B1- 8 684 036
- US-B2- 6 750 571
- YOSHIYA NAKAMURA ET AL: "Development of active six-degrees-of-freedom microvibration control system using giant magnetostrictive actuators", SMART MATERIALS AND STRUCTURES, IOP PUBLISHING LTD., BRISTOL, GB, vol. 9, no. 2, 1 April 2000 (2000-04-01), pages 175 - 185, XP020071344, ISSN: 0964-1726, DOI: 10.1088/0964-1726/9/2/308

## Beschreibung

### Gebiet der Erfindung

Die Erfindung betrifft ein Schwingungsisolationssystem mit einem Magnetaktor. Insbesondere betrifft die Erfindung ein stationäres Schwingungsisolationssystem, auf welchem magnetisch empfindliche Geräte, beispielsweise Geräte zur Prozessierung von Halbleiterbauelementen oder hochpräzise Messinstrumente wie Elektronenmikroskope, platziert sind.

Die Erfindung betrifft des Weiteren einen Magnetaktor für ein Schwingungsisolationssystem.

### Hintergrund der Erfindung

Aktive Schwingungsisolationssysteme sind aus der Praxis bekannt. Insbesondere in der Halbleiterindustrie werden Schwingungsisolationssysteme verwendet, bei welchen ein Gerät zur Prozessierung von Halbleiterbauelementen, beispielsweise ein Gerät zur Belichtung oder Inspektion von Wafern, auf zumindest drei Schwingungsisolatoren gelagert ist.

Das Dokument YOSHIYA NAKAMURA ET AL: "Development of active six-degrees-of-freedom microvibration control system using giant magnetostrictive actuators", SMART MATERIALS AND STRUCTURES, IOP PUBLISHING LTD., BRISTOL, GB, Bd. 9, Nr. 2, 1. April (2900-94-01), zeigt einen Ansatz für ein aktives Mikrovibrationskontrollsystem, basierend auf sog. "giant magnetostrictive actuators". Hiermit kann Vibrationen entgegengewirkt werden.

Auch für hochpräzise Messinstrumente wie Elektronenmikroskope oder Transmissions-Elektronenmikroskope ("TEM") werden Schwingungsisolationssysteme verwendet, auf denen diese Geräte platziert werden. Transmissions-Elektronenmikroskope ermöglichen eine direkte Abbildung von Objekten mithilfe von Elektronenstrahlen. Für den Betrieb derartiger Mikroskope werden besonders hohe Anforderungen gestellt, einerseits in Bezug auf mögliche Schwingungen, denen das System ausgesetzt ist, andererseits aber auch in Bezug auf möglicherweise störende Magnetfelder.

Ein aktives Schwingungsisolationssystem umfasst dabei Sensoren an der schwingungsisoliert gelagerten Last und/oder am Boden, über welche Schwingungen erfasst werden. Anhand der erfassten Schwingungen wird mittels eines Controllers ein Aktor angesteuert, welcher an der schwingungsisoliert gelagerten Last angreift und Gegenkräfte erzeugt, um die Schwingungen der schwingungsisoliert gelagerten Last zu reduzieren.

Als Aktoren werden insbesondere Magnetaktoren verwendet. Diese sind nach dem Prinzip eines Linearmotors aufgebaut und haben den Vorteil, dass sich auf kleinem Bauraum verhältnismäßig große Kräfte in einem breiten Frequenzbereich erzeugen lassen.

Nachteilig an bekannten Magnetaktoren sind allerdings die von den Permanentmagneten und/oder den Spulen erzeugten Magnetfelder.

Diese können magnetisch empfindliche Geräte, wie beispielsweise Rasterelektronenmikroskope oder Transmissions-Elektronenmikroskope, stören und können daher oft nicht in der Nähe des Geräts eingebaut werden.

Dies führt dazu, dass magnetisch empfindliche Geräte, beispielsweise Geräte zur Prozessierung von Halbleiterbauelementen oder hochpräzise Messinstrumente wie Elektronenmikroskope oder insbesondere Transmissions-Elektronenmikroskope, nicht in Verbindung mit stationären Schwingungsisolationssystemen betrieben werden können, welche mit Magnetaktoren arbeiten, da die magnetischen Felder der Magnetaktoren die Messergebnisse beeinflussen oder verfälschen können.

Dies führt zu einem weiteren Nachteil, welcher darin liegt, dass infolgedessen derartige hochpräzise Messinstrumente häufig nicht in der direkten Umgebung von Produktionsanlagen oder anderen Einrichtungen, von welchen Bodenschwingungen ausgehen können, betrieben werden können, da die oben genannten stationären Schwingungsisolationssysteme mit Magnetaktoren aufgrund der durch die Magnetfelder hervorgerufenen Störungen nicht verwendet werden können.

Dieser Aufgabe haben sich die Erfinder angenommen.

### Aufgabe der Erfindung

Der Erfindung liegt demgegenüber die Aufgabe zugrunde, die genannten Nachteile des Standes der Technik zumindest zu reduzieren.

Insbesondere ist es eine Aufgabe der Erfindung, ein stationäres Schwingungsisolationssystem mit Magnetaktoren zur Verfügung zu stellen, welches auch in Verbindung mit Geräten zur Prozessierung von Halbleiterbauelementen oder hochpräzisen Messinstrumenten wie Elektronenmikroskopen oder insbesondere Transmissions-Elektronenmikroskopen, verwendet werden kann.

Die Erfindung soll es damit ermöglichen, derartige Geräte und Instrumente auch in der näheren Umgebung von Produktionsanlagen oder anderen Einrichtungen, von welchen Bodenschwingungen ausgehen können, zu betreiben, ohne dass der Betrieb dieser Geräte oder Instrumente beeinträchtigt wird, etwa durch Magnetfelder des Schwingungsisolationssystems.

### Zusammenfassung der Erfindung

Die Aufgabe der Erfindung wird bereits durch ein Schwingungsisolationssystem sowie einen Magnetaktor für ein Schwingungsisolationssystem nach einem der unabhängigen Ansprüche gelöst.

Bevorzugte Ausführungsformen und Weiterbildungen der Erfindung sind dem Gegenstand der abhängigen Ansprüche, der Beschreibung sowie den Zeichnungen zu entnehmen.

Die Erfindung betrifft ein Schwingungsisolationssystem, welches eine schwingungsisoliert gelagerte Last umfasst, wobei das Schwingungsisolationssystem zumindest einen über einen Controller angesteuerten Magnetaktor aufweist.

Die Erfindung betrifft insbesondere ein stationäres Schwingungsisolationssystem, bei welchem eine Platte auf zumindest drei Schwingungsisolatoren schwingungsisoliert gelagert ist. Das Schwingungsisolationssystem dient insbesondere der Aufnahme von Geräten zur Prozessierung von Halbleiterbauelementen, wie beispielsweise Lithografiegeräten oder Waferinspektionsgeräten und/oder der Aufnahme von hochpräzisen Messinstrumenten wie Elektronenmikroskopen oder insbesondere Transmissions-Elektronenmikroskopen.

Mit von der Erfindung umfasst ist demnach in einem weiteren Aspekt ein hochpräzises Messinstrument beziehungsweise eine hochpräzise, abbildende optische Vorrichtung, insbesondere ein Mikroskop, ein Elektronenmikroskop oder ein Transmissions-Elektronenmikroskop, umfassend ein Schwingungsisolationssystem mit zumindest drei Schwingungsisolatoren, wobei bevorzugt zumindest ein Schwingungsisolator einen Magnetaktor umfasst, besonders bevorzugt jeder der Schwingungsisolatoren.

Das erfindungsgemäße Schwingungsisolationssystem ist damit geeignet, in Geräten der oder in Verbindung mit der Elektronenenergieverlustspektroskopie ("EELS" = electron energy loss spectroscopy) verwendet zu werden.

Mittels derartiger Verfahren können beispielsweise stöchiometrische und elektronische Charakterisierungen anorganischer oder organischer Strukturen durchgeführt werden. Bei der Elektronenenergieverlustspektroskopie, welche häufig mittels Transmissions-Elektronenmikroskopen erfolgt, wird das Spektrum des Energieverlustes zunächst monoenergetischer oder monochromatischer Elektronen nach einer Wechselwirkung mit einer Probe bestimmt.

Unter dem Begriff "monoenergetisch" wird hierbei verstanden, dass die Breite der Energieverteilung der Primärelektronen möglichst klein sein soll gegenüber der Breite des gemessenen Spektrums, da die Breite der Verteilung die erreichbare spektrale Auflösung des Verfahrens bedingt. Die Primärelektronen treten dabei über ihr elektrisches Feld in eine Wechselwirkung mit den geladenen Teilchen der Probe (in Atomkernen mit Neutronen zusammengefasste Protonen sowie Elektronen). Da die Atomkerne sehr viel massereicher sind als einzelne Elektronen, ist der Energieübertrag von den Primärelektronen auf die Atomkerne eher vernachlässigbar. Dagegen kann es bei der Wechselwirkung mit den Festkörperelektronen zu merklichen Energieverlusten kommen, welche anhand der charakteristischen Wahrscheinlichkeitsverteilung für Energieüberträge bestimmt werden kann.

Dabei ist es wichtig, dass im Bereich der Probe, welche gemessen werden soll, möglichst kein oder nur ein sehr geringes störendes Magnetfeld vorhanden ist und insbesondere kein störendes Magnetfeld durch die Schwingungsisolatoren erzeugt wird, um hochpräzise Messungen ohne Überlagerung durch derartige Magnetfelder zur Verfügung durchführen zu können.

Dieser Bereich, welcher der Aufnahme der Probe während der Messung dient, wird nachfolgend auch als Messbereich bezeichnet. Ein zusätzliches Magnetfeld, welches in den Messbereich hineinragt, kann hingegen die Primärelektronen ablenken und damit die Messergebnisse verfälschen.

Der Messbereich der abbildenden optischen Vorrichtung befindet sich dabei in einer bevorzugten Ausführungsform möglichst weit entfernt von den Schwingungsisolatoren, insbesondere von dem zumindest einen Magnetaktor, da bereits aufgrund des Abstands eine gewisse Abschwächung des magnetischen Feldes des Magentaktors erfolgen kann.

Bei einer Anordnung mit beispielsweise drei voneinander beabstandeten Schwingungsisolatoren, insbesondere Magnetaktoren, kann dabei der Messbereich besonders günstig im Bereich des Umkreismittelpunktes des durch die drei Schwingungsisolatoren gebildeten Dreiecks liegen.

Bei einer Anordnung mit beispielsweise vier voneinander beabstandeten Schwingungsisolatoren, insbesondere Magnetaktoren, kann dabei der Messbereich besonders günstig im Bereich des Mittelpunktes des durch die vier Schwingungsisolatoren gebildeten Rechtecks oder Quadrates liegen.

Im Allgemeinen ist es günstig, wenn der Messbereich einen gleichen Abstand zu sämtlichen Schwingungsisolatoren des Schwingungsisolationssystems aufweist, zumindest zu denjenigen, welche Magnetaktoren umfassen. Als Messbereich wird ein räumlicher Bereich, beispielsweise in Form eines Würfels oder Quaders verstanden, in der Regel mit einer Aufnahme für die Probe, wobei eine zu messende Probe zumindest teilweise in diesem Bereich platziert wird, um die Messung vorzunehmen. Sofern von einem Abstand des Messbereiches gesprochen wird, wird hierunter der Abstand zu dem Schwerpunkt dieses räumlichen Bereiches, also beispielsweise des Würfels, oder dem Mittelpunkt der Aufnahme für die Probe verstanden.

Der Magnetaktor greift an der schwingungsisoliert gelagerten Last an und erzeugt Gegenkräfte zur Reduktion von Schwingungen in zumindest einer Raumrichtung.

Der Magnetaktor ist insbesondere als Linearmotor ausgebildet und umfasst einen Spulenträger mit zumindest einer Spule, welcher in einem U-förmig ausgebildeten Magnetträger angeordnet ist. Diese Grundanordnung des erfindungsgemäßen Magnetaktors ermöglicht es besonders günstig, die baulichen Komponenten derart zu optimieren, dass die geforderte sehr hohe Abschirmung ermöglicht werden kann, um Messungen ohne störende Magnetfelder durchführen zu können.

Gemäß der Erfindung umfasst der Magnetaktor eine magnetische Abschirmung.

Die Erfindung sieht also vor, den Magnetaktor mit einer als magnetische Abschirmung dienenden Einhausung zu versehen.

Die magnetische Schirmung besteht insbesondere aus einem Weichmetall.

Durch die magnetische Abschirmung wird das im Inneren des Magnetaktors vorhandene oder entstehende Magnetfeld umgelenkt und gebündelt, so dass es sich außerhalb stark abschwächt.

Die magnetische Abschirmung besteht insbesondere aus einem Material mit einer Permeabilitätszahl µᵣ von über 1.000, vorzugsweise von über 10.000 und besonders bevorzugt von über 50.000.

Insbesondere besteht die magnetische Abschirmung aus einem Mu-Metall. Es handelt sich dabei um eine weichmagnetische Eisen-Nickel-Legierung, welche typischerweise eine Permeabilitätszahl µᵣ von 80.000 bis 500.000 hat.

Die magnetische Abschirmung ist vorzugsweise als Gehäuse mit einer Öffnung in einer Wand ausgebildet, aus welcher ein Arm des Magnetaktors, insbesondere ein Spulenträger, herausragt.

Die Öffnung ist vorzugsweise so bemessen, dass der Spulenträger berührungslos in den Magnetträger hineinragt, der sich um den Spulenträger erstreckende Spalt aber möglichst klein gehalten ist, insbesondere eine maximale Breite von weniger als 2 mm, vorzugsweise weniger als 1 mm hat.

Die magnetische Abschirmung kann insbesondere als rechteckig ausgebildetes Gehäuse mit zusammengesetzten Wänden bereitgestellt sein. Die Permeabilität schwächende Verformungen des Materials müssen so zu dessen Herstellung nicht vorgenommen werden.

Bei einer anderen Ausführungsform umfasst der Magnetaktor eine Umwicklung mit einer magnetischen Abschirmung. Diese kann insbesondere mehrlagig ausgebildet sein. So werden trotz der Umwicklung die Permeabilität schwächende Verformungen geringgehalten.

Es hat sich gezeigt, dass bereits recht dünne Umwicklungen aus Mu-Metall, insbesondere mehrlagige Umwicklungen mit einer Gesamtdicke von unter 1 mm, vorzugsweise unter 0,5 mm zu einer deutlichen Reduktion des von den Magnetaktoren verursachten Feldes führen.

Die magnetische Abschirmung kann insbesondere eine Dicke von 0,1 bis 10 mm, vorzugsweise von 0,2 bis 1 mm, aufweisen.

Gemäß einer Ausführungsform der Erfindung ist der Magnetaktor in einem Schwingungsisolator integriert. Der Schwingungsisolator umfasst eine Feder und dient der schwingungsisolierten Lagerung der zu isolierenden Last.

Die Feder kann beispielsweise als pneumatische Feder ausgebildet sein. Der erfindungsgemäße Magnetaktor kann in dem Isolator, beispielsweise im Arbeitsraum der pneumatischen Feder, oder im Gehäuse der pneumatischen Feder angeordnet sein.

Die Erfindung ermöglicht auch das Anbringen eines Magnetaktors in der Nähe eines Gerätes zur Prozessierung von Halbleiterbauelementen. Insbesondere kann der erfindungsgemäße Magnetaktor auch in einem Abstand von weniger als 50 cm von einem Gerät zur Prozessierung von Halbleiterbauelementen, beispielsweise von einem Rasterelektronenmikroskop, platziert sein.

In besonders günstiger Weise ermöglicht es der erfindungsgemäße Magnetaktor aufgrund der Abschirmung auch, an oder in Verbindung mit einer hochpräzisen, abbildenden optischen Vorrichtung, insbesondere einem Mikroskop, einem Elektronenmikroskop oder einem Transmissions-Elektronenmikroskop betrieben werden zu können.

So kann eine hochpräzise, abbildende optische Vorrichtung mit einer Anordnung von Schwingungsisolatoren, insbesondere mit Magnetaktoren, zur Verfügung gestellt werden, bei der im Betrieb in einem Abstand von weniger als 70 cm, weniger als 50 cm, bevorzugt weniger als 45 cm und besonders bevorzugt von weniger als 40 cm von zumindest einem Schwingungsisolator, insbesondere Magnetaktor, das Magnetfeld während des Betriebs unter 15 nT, bevorzugt unter 10 nT und besonders bevorzugt unter 9 nT liegt.

Diese hohe Abschirmung ermöglicht es damit, zum einen auch Anordnungen mit mehr als drei Schwingungsisolatoren, insbesondere Magnetaktoren, vorzugsweise vier oder sogar mehr zur Verfügung zu stellen. Eine Anordnung mit vier anstelle von drei derartigen Schwingungsisolatoren, insbesondere Magnetaktoren, ermöglicht eine deutlich stabilere Ausführung der abbildenden optischen Vorrichtung und kann beispielsweise ein unbeabsichtigtes Umkippen der Vorrichtung besser verhindern.

Die Abschirmung ermöglicht es zudem, die abbildende optische Vorrichtung auch in Arbeitsumgebungen oder zu Zeiten betreiben zu können, in welchen mit Schwingungen zu rechnen ist. Das oben genannte geringe Magnetfeld innerhalb des Messbereiches konnte beispielsweise realisiert werden für ein Schwingungsisolationssystem in einer Testumgebung mit einer peak-to-peak Bodenschwingungsamplitude von 20 µm und bei 0,5 Hz.

Die hohe Abschirmung des Magnetaktors ermöglicht zum anderen vergleichsweise kleine Bauformen, da das Schwingungsisolationssystem und damit die abbildende optische Vorrichtung auch sehr kompakt gehalten werden kann, da die Magnetaktoren vergleichsweise dicht an den Messbereich heranrücken können.

Bei einer weiteren bevorzugten Ausführungsform umfasst das Schwingungsisolationssystem zumindest zwei Magnetaktoren zum Erzeugen von Kompensationssignalen in zwei zumindest zwei unterschiedlichen Raumrichtungen.

Die Erfindung betrifft des Weiteren einen Magnetaktor für ein Schwingungsisolationssystem, insbesondere für das vorstehend beschriebene Schwingungsisolationssystem.

Der Magnetaktor umfasst einen Magnetträger mit sich gegenüberliegenden Magneten.

Der Magnetträger ist insbesondere U-förmig mit zwei sich gegenüberliegenden Schenkeln ausgebildet, wobei die Magnete sich paarweise gegenüberliegen und die Pole der Magnete sich ebenfalls gegenüberliegen, also die entgegengesetzten Pole gegenüber angeordnet sind.

Zwischen den Magneten ist berührungslos ein Spulenträger mit zumindest einer Spule angeordnet.

Des Weiteren umfasst der Magnetaktor eine magnetische Abschirmung, welche eine Öffnung umfasst, aus welcher der Spulenträger herausragt.

Der Magnetaktor kann insbesondere wie vorstehend im Zusammenhang mit dem Schwingungsisolationssystem beschrieben ausgebildet sein, also die vorstehenden, im Zusammenhang mit dem Magnetaktor beschriebenen Merkmale aufweisen.

Insbesondere kann die Abschirmung aus einem Material mit einer Permeabilitätszahl µᵣ von über 1.000, vorzugsweise über 10.000 und besonders bevorzugt über 50.000 bestehen.

Beispielsweise besteht die magnetische Abschirmung aus einem Mu-Metall.

Gemäß einer Ausführungsform umgibt die magnetische Abschirmung den Magnetträger.

Gemäß dieser Ausführungsform der Erfindung ist die magnetische Abschirmung also als zusätzliches Gehäuse ausgebildet, welches sich um den ansonsten aus dem Stand der Technik bekannten Magnetaktor erstreckt.

Diese Ausführungsform der Erfindung hat den Vorteil, dass das Material der magnetischen Abschirmung einzig und allein auf eine besonders gute magnetische Abschirmung optimiert sein muss.

Gemäß einer anderen Ausführungsform der Erfindung bildet der Magnetträger selbst einen Teil der magnetischen Abschirmung.

Gemäß dieser Ausführungsform der Erfindung ist also der Magnetträger aus einem derartigen Material gefertigt und derart dimensioniert, dass die Schenkel des Spulenträgers und die Verbindungsplatte für die beiden Schenkel bereits eine Abschirmung bilden.

Vorzugsweise wird für diese Ausführungsform der Erfindung kein Mu-Metall, sondern ein ferromagnetisches Weicheisen verwendet, welches billiger ist und sich einfacher verarbeiten lässt.

Die so als Abschirmung dienenden Wände müssen gegenüber einem Mu-Metall dicker ausgebildet sein, um die gleiche Abschirmung zu erreichen.

Die offenen Seiten des U-förmigen Magnetträgers werden gemäß dieser Ausführungsform der Erfindung mit als Abschirmung dienenden Wänden versehen.

Vorzugsweise umfasst das so gleichzeitig als Magnetträger und Abschirmung dienende Gehäuse lediglich eine einzige Öffnung, in welche der Spulenträger berührungslos hineinragt.

Gemäß der Erfindung umfasst der Magnetaktor zum Erzeugen möglichst hoher Kräfte zumindest zwei sich gegenüberliegende Magnetpaare, zwischen denen die Windungen der Spule angeordnet sind.

Eine besonders günstige Anordnung sieht demnach zumindest zwei sich gegenüberliegende Magnetpaare mit entsprechend dazwischen angeordneten Windungen der Spule vor, wobei vorzugsweise ebenfalls zwei derartige Windungen der Spule vorgesehen sind.

In anderen Worten, zwischen einem sich gegenüberliegenden Magnetpaar sind jeweils die Windungen einer Spule angeordnet, und in einem vorbestimmten Abstand hierzu folgt ein weiteres sich gegenüberliegendes Magnetpaar mit wiederum Windungen einer Spule dazwischen. Dies ermöglicht eine gute Kraftübertragung bei gleichzeitiger Minimierung des im Betrieb erforderliche Magnetfeldes.

Daraus folgt, dass auch mehrere Windungen der Spule bzw. Windungsanordnungen vorgesehen sind, welche zueinander beabstandet sein können und günstigerweise korrespondierend zu den sich gegenüberliegenden Magnetpaaren angeordnet sind. Es könnten auch mehr als zwei derartige sich gegenüberliegenden Magnetpaare mit jeweils einer Windungsanordnung, beispielsweise drei Magnetpaare mit Windungsanordnung, vorgesehen sein, wobei jeweils ein Abstand zwischen diesen Anordnungen vorgesehen ist, um das im Betrieb erforderliche Magnetfeld bereits auf ein Minimum reduzieren zu können. Der Abstand zwischen benachbarten Magnetpaaren und/oder zwischen benachbarten Windungsanordnungen kann dabei in einem Bereich zwischen 1 und 60 mm, bevorzugt zwischen 2 und 20 mm liegen.

In einer besonders günstigen Ausführungsform wird weiterhin der Abstand zwischen den Windungen der Spule und den Magneten minimiert, um die erforderliche Antriebsenergie ebenfalls auf ein Minimum reduzieren zu können. Günstigerweise beträgt dieser Abstand weniger als 2 mm, bevorzugt weniger als 1 mm.

In einer ebenfalls günstigen Ausführungsform ist der Spulenträger aus oder umfasst ferromagnetisches Weicheisen für eine gute Permeabilität, um die Magnetisierung im Bereich des Spulenträgers zu begünstigen.

In einer nochmaligen Weiterbildung der Erfindung kann der Spulenträger noch mit einer zusätzlichen Abschirmung ausgebildet sein, welche insbesondere in demjenigen Bereich des Spulenträgers angebracht sein kann, welche sich außerhalb der Abschirmung befindet. Auch können die Bereiche bzw. die Oberflächen des Spulenträgers zwischen den Windungsanordnungen mit einer Abschirmung ausgebildet sein.

### Kurzbeschreibung der Zeichnungen

Der Gegenstand der Erfindung soll im Folgenden anhand schematisch dargestellter Ausführungsbeispiele gemäß Fig. 1 bis Fig. 3 sowie anhand eines perspektivisch dargestellten Ausführungsbeispiels anhand Fig. 4 und 5 näher erläutert werden.

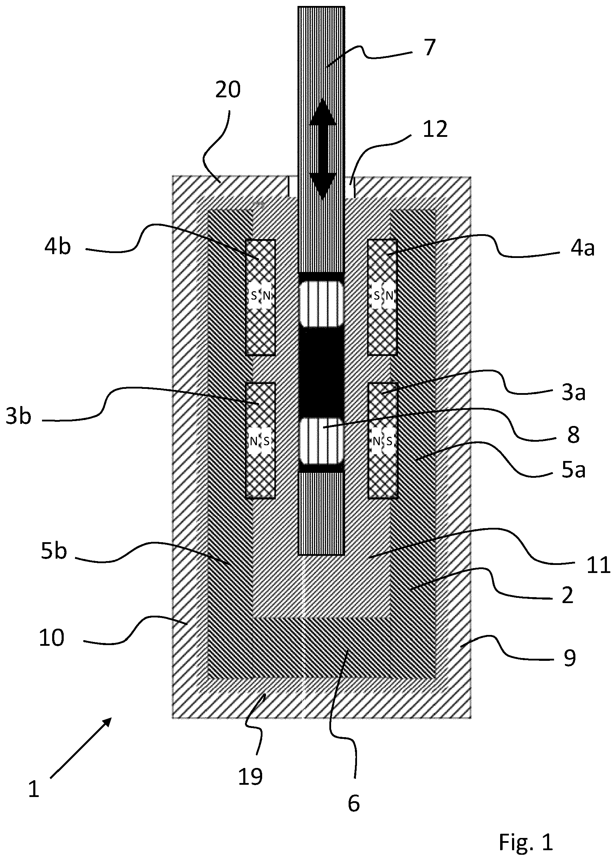

Fig. 1 zeigt in einer schematischen Schnittansicht ein erstes Ausführungsbeispiel der Erfindung, bei welchem der Magnetaktor als magnetische Abschirmung eine Einhausung aus einem Material mit hoher Permeabilitätszahl aufweist.

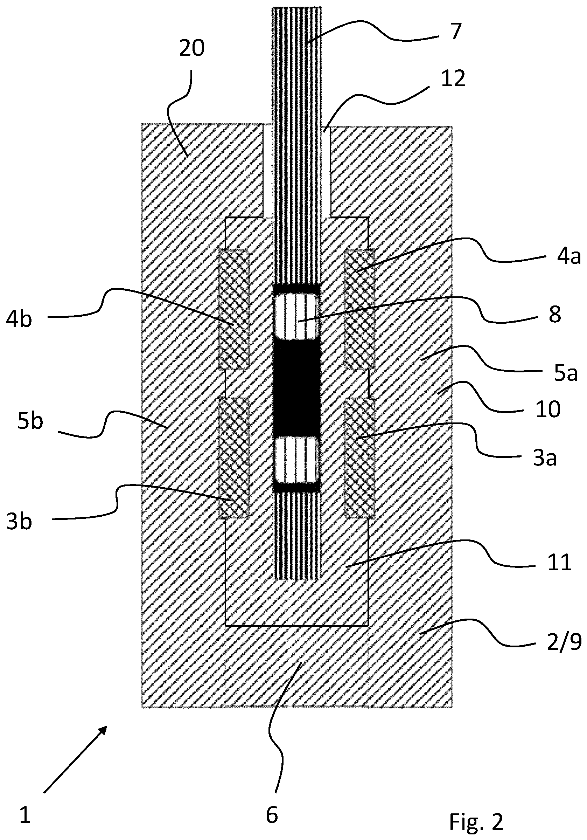

Fig. 2 zeigt schematisch eine alternative Ausführungsform der Erfindung, bei welcher der Magnetträger des Magnetaktors gleichzeitig Teil der magnetischen Abschirmung ist.

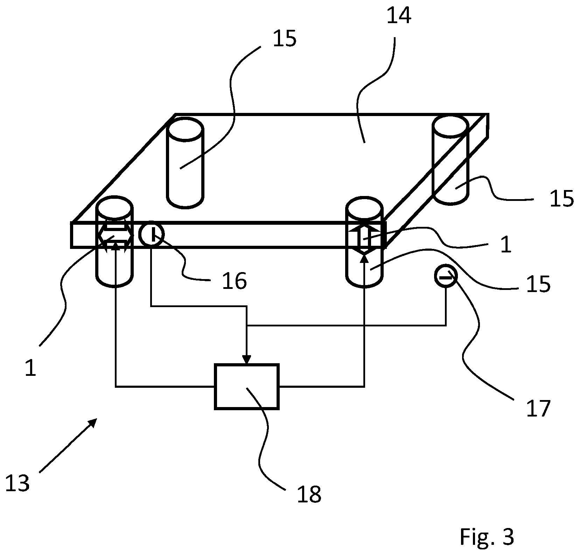

Fig. 3 ist eine schematische Ansicht eines Schwingungsisolationssystems, in welchem der erfindungsgemäße Magnetaktor eingebaut ist.

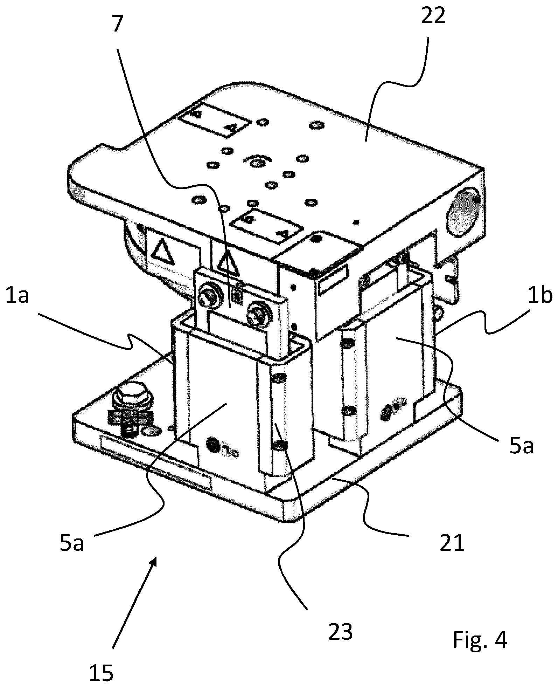

Fig. 4 ist eine perspektivische Ansicht eines Schwingungsisolators, welcher mit zwei Magnetaktoren versehen ist.

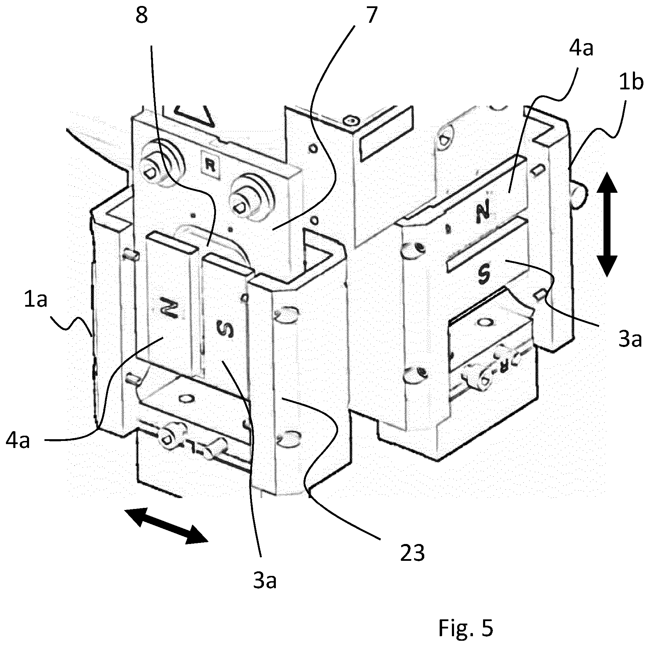

Fig. 5 ist eine Detailansicht, in welcher das Innere der Magnetaktoren dargestellt ist.

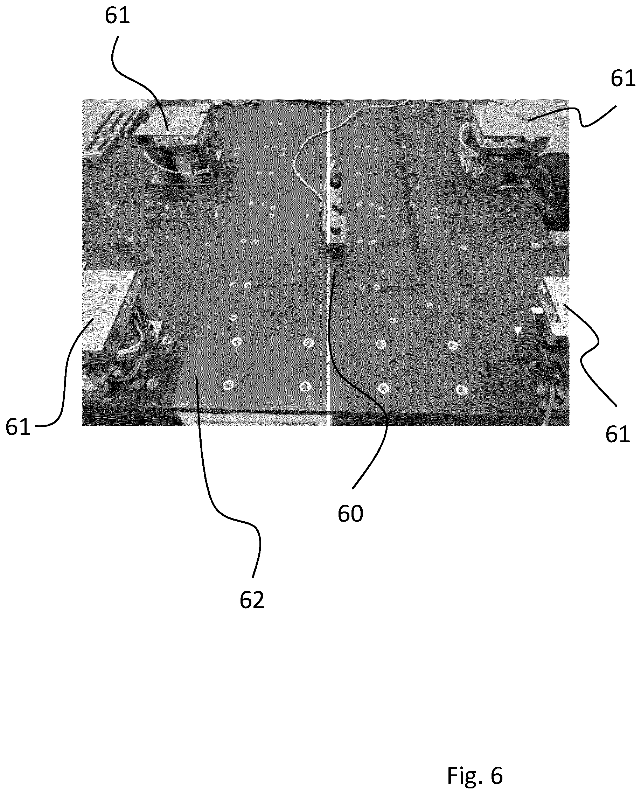

Fig. 6 zeigt in einer Draufsicht eine Versuchsanordnung zur Bestimmung des Magnetfeldes in einem vorbestimmten Abstand zu Magnetaktoren.

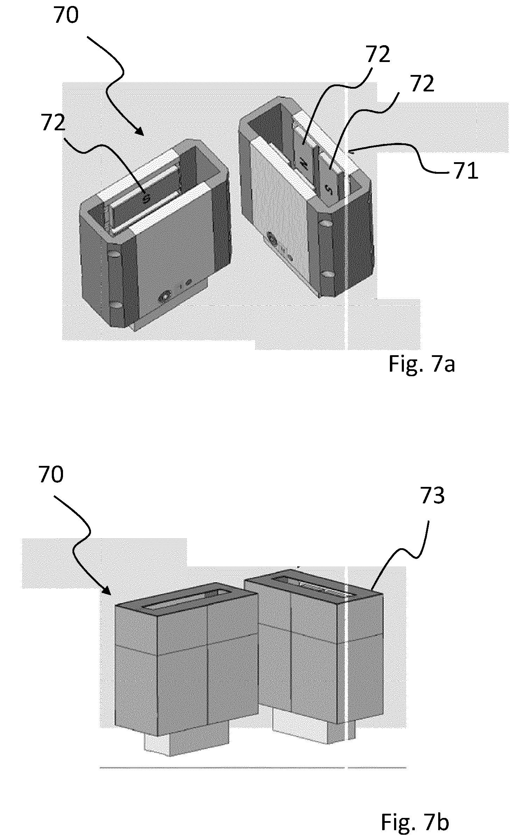

Die Figuren 7a und 7b zeigen schematisch in einer Schrägansicht einen Magnetaktor mit Magneten und einem Träger.

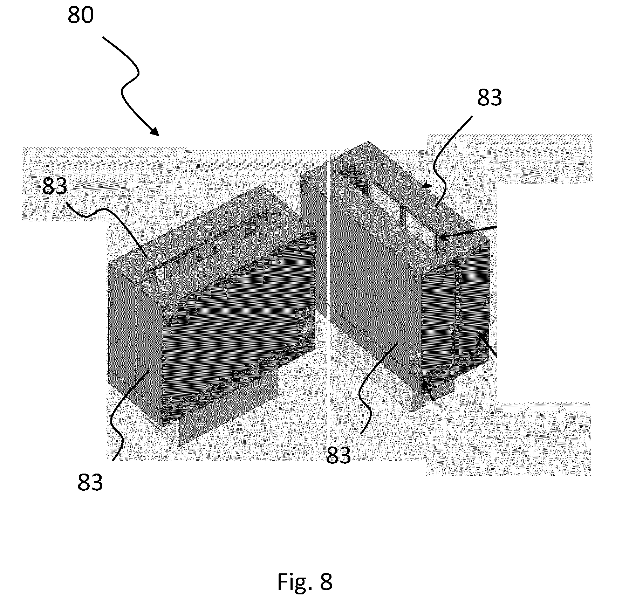

Fig. 8 zeigt schematisch in einer Schrägansicht einen Magnetaktor mit einer verbesserten magnetischen Abschirmung, welche in den bzw. mit dem Träger integriert ist.

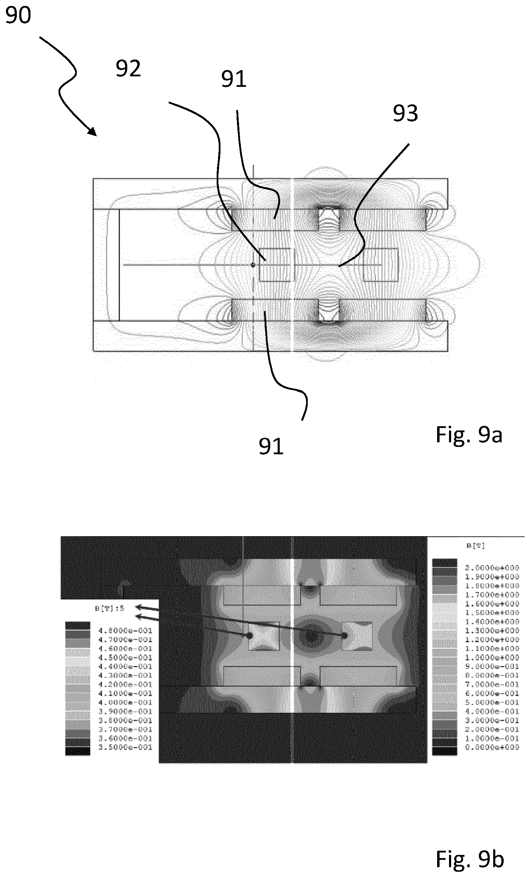

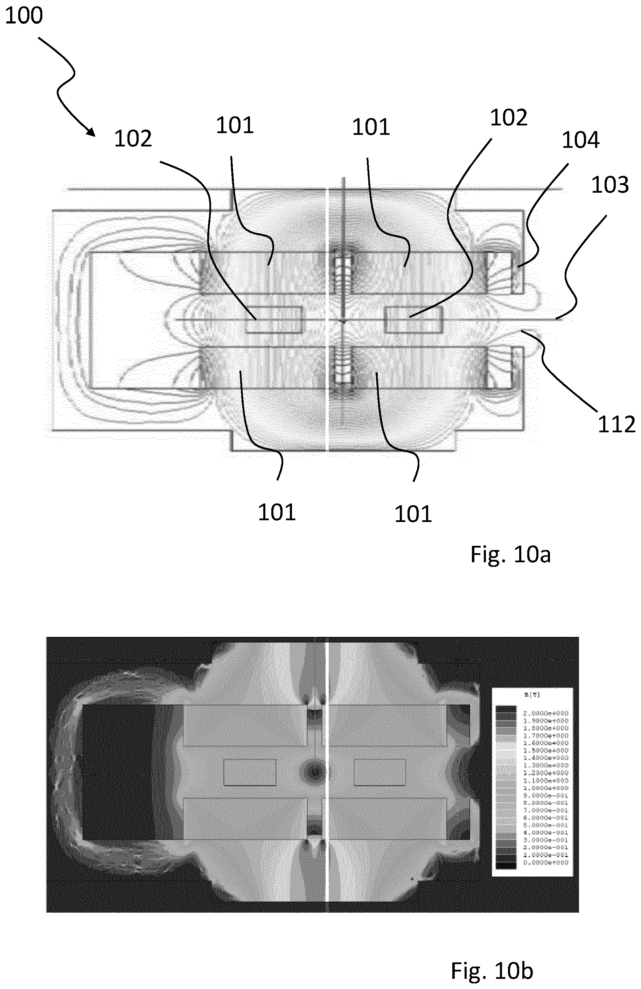

Die Figuren 9a, 9b, 10a und 10b zeigen schematisch den Unterschied der Magnetfelder anhand eines Vergleiches der Magnetfelder für eine Anordnung von Magnetpaaren und Windungen der Spule mit größerem Abstand sowie mit geringerem Abstand.

### Detaillierte Beschreibung der Zeichnungen

Fig. 1 zeigt in einer schematischen Schnittansicht ein Ausführungsbeispiel eines Magnetaktors 1, welcher zur Verwendung in einem Schwingungsisolationssystem vorgesehen ist.

Der Magnetaktor 1 umfasst einen Magnetträger 2.

Der Magnetträger 2 ist U-förmig ausgebildet und umfasst zwei sich gegenüberliegende Schenkel 5a, 5b, welche auf einer Seite mittels der Platte 6 miteinander verbunden sind.

An den Schenkeln 5a, 5b angebracht sind in diesem Ausführungsbeispiel zwei sich jeweils gegenüberliegende Magnetpaare 3a, 3b sowie 4a, 4b vorgesehen.

Die Magnete 3a, 3b, 4a, 4b sind an den Schenkeln 5a, 5b befestigt, insbesondere eingeklebt.

Die Pole der Magnetpaare 3a, 3b sowie 4a, 4b liegen sich jeweils gegenüber. Dementsprechend läuft das Magnetfeld jeweils von einem Schenkel 5a zum anderen Schenkel 5b.

Die Magnete 3a, 3b, 4a, 4b sind in diesem Ausführungsbeispiel derart angeordnet, dass die Magnetfelder der beiden Magnetpaare 3a, 3b sowie 4a, 4b entgegengesetzt ausgerichtet sind.

In den Magnetträger 2 ragt berührungslos der in diesem Ausführungsbeispiel plattenförmig ausgebildete Spulenträger 7 hinein, welcher die Spule 8 umfasst, deren Windungen sich zwischen den Magnetpaaren 3a, 3b sowie 4a, 4b erstrecken.

Durch Beaufschlagen der Spule 8 mit einem Stromfluss und die daraus resultierende Erzeugung eines magnetischen Feldes kann mittels des Magnetaktors 1 eine Kraft in zwei Richtungen (je nach Stromflussrichtung, mit dem Pfeil gekennzeichnet) erzeugt werden.

Der Spulenträger 7 kann dabei beispielsweise an der zu isolierenden Last angreifen. Es ist aber genauso gut die umgekehrte Anordnung denkbar, bei welcher der Magnetträger 2 an der schwingungsisoliert gelagerten Last angeordnet ist und der Spulenträger 7 an der Basis des Schwingungsisolationssystems angreift.

Erfindungsgemäß umfasst der Magnetaktor 1 eine magnetische Abschirmung 9.

Die magnetische Abschirmung 9 ist in diesem Ausführungsbeispiel als Einhausung des Magnetträgers 2 ausgebildet.

Die magnetische Abschirmung umfasst die Seitenwände 10 sowie die Rückwand 11. Die Vorderwand ist in dieser Schnittansicht nicht zu sehen.

Die magnetische Abschirmung 9 erstreckt sich auch entlang einer Unterseite 19 und einer Oberseite 20 eines durch die magnetische Abschirmung 9 gebildeten Gehäuses.

Die magnetische Abschirmung 9 weist lediglich eine Öffnung 12 auf, durch welche der Spulenträger 7 berührungslos in das durch die magnetische Abschirmung 9 gebildete Gehäuse bis in den Magnetträger 2 hineinragt.

Die Öffnung ist vorzugsweise derart ausgebildet, dass diese nur einen schmalen Spalt ausbildet, welcher sich um den Spulenträger 7 erstreckt.

Die magnetische Abschirmung 9 ist in diesem Ausführungsbeispiel vorzugsweise aus einem Mu-Metall ausgebildet.

Insbesondere kann es sich bei der Abschirmung um eine mehrlagige Umwicklung aus Mu-Metall handeln.

Fig. 2 ist eine schematische Ansicht einer alternativen Ausführungsform der Erfindung.

Im Gegensatz zu der in Fig. 1 dargestellten Ausführungsform dient der Magnetträger 2 gleichzeitig als magnetische Abschirmung.

Die Schenkel des Magnetträgers 2 ist dicker ausgebildet als in dem Ausführungsbeispiel gemäß Fig. 2 und bilden die Seitenwände 10 der magnetischen Abschirmung 9 aus.

Die Platte 6 zur Verbindung der Schenkel 5a, 5b des Magnetträgers 2 dient als Boden.

Im Unterschied zu aus dem Stand der Technik bekannten Magnetaktoren ist eine Rückwand 11 sowie eine Vorderwand (nicht dargestellt) vorgesehen. Lediglich in der Oberseite 20 des so durch die magnetische Abschirmung 9 gebildeten Gehäuses ist entsprechend Fig. 1 eine Öffnung 12 vorgesehen, durch welche der Spulenträger 7 mit den Spulen 8a und 8b berührungslos in das durch die magnetische Abschirmung 9 gebildete Gehäuse hineinragt, so dass die Spule 8 zwischen den Magnetpaaren 3a, 3b und 4b, 4b entlangläuft.

Fig. 3 ist eine schematische Ansicht eines Schwingungsisolationssystems, in welchem der in Fig. 1 oder Fig. 2 dargestellte Magnetaktor verwendet wird.

Das Schwingungsisolationssystem 13 ist als aktives Schwingungsisolationssystem ausgebildet und umfasst eine Platte 14, welche auf Schwingungsisolatoren 15, beispielsweise auf Luftfedern, schwingungsisoliert gelagert ist.

Die Platte 15 dient der Aufnahme eines Gerätes zur Prozessierung von Halbleiterbauelementen (nicht dargestellt).

In diesem Ausführungsbeispiel sind die Magnetaktoren 1 zur aktiven Schwingungsisolation in dem Gehäuse der Schwingungsisolatoren 15 integriert.

Das Schwingungsisolationssystem ist derart ausgebildet, dass das von den Magnetaktoren im Betrieb verursachte Magnetfeld in der Mitte der Platte 14 immer unter 10 nT liegt.

Das Schwingungsisolationssystem umfasst zumindest einen Sensor 16 an der schwingungsisoliert gelagerten Last und/oder am Boden 17.

Das Signal des oder der Sensoren 16, 17 wird von einem Controller 18 verarbeitet, welcher die Magnetaktoren 1 zur aktiven Reduktion von Schwingungen ansteuert. Es kann so der Prolongation von außen auf das System einwirkenden Schwingungen entgegengewirkt werden.

Weiter können auch Schwingungen, die von der schwingungsisoliert gelagerten Last, wie beispielsweise einer verfahrbaren Bühne, verursacht werden, entgegengewirkt werden.

Aufgrund der magnetischen Abschirmung der Magnetaktoren 1 können diese auch nah an einem gegenüber magnetischen Feldern empfindlichen Gerät angeordnet sein.

Fig. 4 ist eine perspektivische Ansicht eines Ausführungsbeispiels eines Schwingungsisolators 15. Der Schwingungsisolator 15 umfasst ein Unterteil 21, welches im eingebauten Zustand mit dem Boden verbunden wird.

Weiter umfasst der Schwingungsisolator 15 das Oberteil 22, welches mit der schwingungsisolierten Last verbunden wir, insbesondere welches mit der in Fig. 3 dargestellten Platte (Bezugszeichen 14) verbunden wird.

Zwischen Oberteil 22 und Unterteil 21 befindet sich eine pneumatische Feder, welche in dieser Ansicht von den Magnetaktoren 1a, 1b verdeckt ist.

Die Magnetaktoren 1a, 1b sind in diesem Ausführungsbeispiel in etwa randseitig an zwei Ecken des Schwingungsisolators angebracht.

Der Magnetaktor 1a dient der horizontalen Schwingungsisolation.

Zu erkennen ist ein Schenkel 5a.

Der Spulenträger 7 greift zwischen den Schenkel 5a und den gegenüberliegenden Schenkel, welcher in dieser Ansicht nicht dargestellt ist.

Randseitig ist an dem durch die Schenkel gebildeten Magnetträger je ein Seitenteil 23 angeordnet, welches den durch die Schenkel 5a gebildeten Spulenträger verdeckt.

Fig. 5 ist eine Detailansicht des Schwingungsisolators mit teilweise ausgeblendetem Spulenträger, d.h. der vordere Schenkel (5a in Fig. 4) ist bei beiden Magnetaktoren 1a, 1b ausgeblendet. Der Magnetaktor 1b, welcher zur vertikalen Isolation vorgesehen ist, entspricht dem in Fig. 1 dargestellten Aufbau, in welchem zwei Magnetpaare mit gegensätzlicher Polung vertikal in dem Magnetträger übereinander angeordnet sind.

Zu erkennen sind in dieser Ansicht die Magnete 3a und 4a.

So kann über eine Ansteuerung der in dieser Ansicht verdeckten Spule eine Kompensationskraft in vertikaler Richtung erzeugt werden.

Bei dem Magnetaktor 1a für die horizontale Isolation sind die Magnetpaare um 90° gedreht.

Die Magnetpaare, von denen man die Magnete 3a und 4a sieht, sind nicht übereinander, sondern nebeneinander angeordnet.

Die Spule 8 ist derart ausgebildet, dass deren Windungen ebenfalls zwischen den Magnetpaaren hindurchlaufen.

Durch Ansteuerung einer Spule können Kompensationskräfte in horizontaler Richtung erzeugt werden.

Die auf den Spulenträger 7 beispielsweise aufgeklebte Spule 8 hat in diesem Ausführungsbeispiel in der Draufsicht einen im Wesentlichen rechteckigen Querschnitt mit abgerundeten Ecken.

Erfindungsgemäß wird das Gehäuse der hier dargestellten Magnetaktoren 1a, 1b noch mit einer mehrlagigen Abdeckung aus Mu-Metall versehen (nicht dargestellt), über die das von den Magnetaktoren 1a, 1b verursachte Magnetfeld deutlich reduziert wird.

Durch die Erfindung konnte auf recht einfache Weise der Anwendungsbereich von Magnetaktoren in einem Schwingungsisolationssystem vergrößert werden.

Fig. 6 zeigt eine Versuchsanordnung zur Bestimmung des Magnetfeldes in einem vorbestimmten Abstand zu Magnetaktoren. Die abgebildete Anordnung verfügt über vier Schwingungsisolatoren 61, welche als Magnetaktor ausgebildet sind. Derartige Anordnungen gelten als besonders stabil für die Aufnahme entsprechender Instrumente und Vorrichtungen, insbesondere für eine hochpräzise, abbildende optische Vorrichtung wie Mikroskop, Elektronenmikroskop oder Transmissions-Elektronenmikroskop.

In der Versuchsanordnung sind die vier Schwingungsisolatoren 61 in einer gleichmäßigen, rechteckförmigen Anordnung auf einer Grundplatte 62 angeordnet, welche aus Gründen der Stabilität besonders zweckdienlich ist. Im Mittelpunkt dieser rechteckförmigen Anordnung ist auf derselben Seite der Grundplatte 62 ein Magnetfeldsensor bzw. ein Magnetometer 60 zur Messung der magnetischen Flussdichte angebracht, welcher das im Betrieb der Schwingungsisolatoren 61 vorhandene Magnetfeld misst.

Das Magnetometer 60 befindet sich damit in Bezug auf die Schwingungsisolatoren 61 in dem Messbereich, also an der Stelle, an der eine Probe typischerweise gemessen werden würde. Bei dieser Konstellation beträgt der Abstand der Schwingungsisolatoren 61 zueinander zwischen 50 und 80 cm. Im Betrieb konnte gezeigt werden, dass das von den Magnetaktoren 61 im Betrieb verursachte Magnetfeld unter 10 nT und besonders bevorzugt unter 9 nT liegt. Selbst bei einem noch geringeren Abstand der Schwingungsisolatoren 61 zueinander und somit bei einem noch geringeren Abstand zwischen Magnetometer 60 und Schwingungsisolator 61 vergrößerte sich die Stärke des von den Magnetaktoren im Betrieb verursachten Magnetfeldes nur unwesentlich, so dass auch Abstände von weniger als etwa 70 cm, beispielsweise zwischen 30 und 70 cm oder zwischen 35 und 65 Abstand zwischen einem oder mehreren Schwingungsisolatoren 61 und dem Messbereich als hinreichend angesehen werden, um etwa Elektronenmikroskopie oder insbesondere Transmissions-Elektronenmikroskopie betreiben zu können.

Die oben genannten Werte für das Magnetfeld konnten realisiert werden für ein Schwingungsisolationssystem in einer Testumgebung mit einer peak-to-peak Bodenschwingungsamplitude von 20 µm und bei 0,5 Hz.

Die Figuren 7a und 7b zeigen einen Magnetaktor 70 mit Magneten 72 und einem Träger 71, welcher einen einfachen vernickelten Stahl umfasst oder aus diesem gebildet ist. Fig. 7b zeigt eine Abschirmung 73, welche die Seitenwände und die Stirnseite des Trägers 71 umgibt. Die magnetische Abschirmung 73 ist aus Mu-Metall gebildet.

Fig. 8 zeigt einen Magnetaktor 80 mit einer verbesserten magnetischen Abschirmung 83, welche in den bzw. mit dem Träger integriert ist. Bei dieser Ausführungsform ist der Träger aus einem vernickelten Weicheisen gebildet, welches eine bessere Permeabilität aufweist als ein normaler Stahl.

Bei dieser Ausführungsform ist zudem der Abstand zwischen den Windungen der Spule und den Magneten auf ein Minimum reduziert und liegt bei etwa 1 mm. Die integrierte Ausführungsform der Abschirmung bietet zudem den Vorteil, dass die Wandstärke vergrößert werden kann, ohne dass gleichzeitig der Bedarf an Bauraum steigt. In anderen Worten, die magnetische Abschirmung verbessert sich infolge der optimierten Ausbildung der Wände, da diese dicker gestaltet werden können bzw. die magnetische Abschirmung über die gesamte Dicke wirken kann.

Die Figuren 9a, 9b, 10a und 10b zeigen den Unterschied anhand eines Vergleiches der Magnetfelder für eine Anordnung von Magnetpaaren und Windungen der Spule mit größerem Abstand (Fig. 9a und 9b) sowie mit geringerem Abstand (Fig. 10a und 10b).

Bei der Ausführungsform eines Magnetaktors 100, welche in den Fig. 10a und 10b gezeigt ist, ist der Abstand zwischen Magnet 101 und Windungsanordnung 102, also der Windungen der Spule, bzw. zum dem Spulenträger 103 minimiert und beträgt günstigerweise nur noch weniger als 2 mm, bevorzugt weniger als 1 mm, wohingegen dieser Abstand bei der Ausführungsform eines Magnetaktors 90 gemäß Fig. 9a und 9b darüber liegt.

Es zeigt sich, dass in den in den Figuren 10a und 10b abgebildeten Ausführungsformen das Magnetfeld deutlich besser ausgebildet ist. Hierzu trägt auch die seitliche Abschirmung 104 bei, welche nur eine kleine Öffnung 112 zur Durchführung des Spulenträger 103 aufweist.

Die vorliegende Erfindung ermöglicht es damit, ein hochpräzises Messinstrument bzw. eine hochpräzise, abbildende optische Vorrichtung, insbesondere ein Mikroskop, ein Elektronenmikroskop oder ein Transmissions-Elektronenmikroskop, zur Verfügung zu stellen, welche ein Schwingungsisolationssystem mit zumindest drei Schwingungsisolatoren, insbesondere vier Schwingungsisolatoren, wobei bevorzugt zumindest ein Schwingungsisolator einen Magnetaktor umfasst, besonders bevorzugt jeder der Schwingungsisolatoren.

Das erfindungsgemäße Schwingungsisolationssystem ermöglicht eine bessere Auflösung für den Anwender und/oder umfassendere Einsatzmöglichkeiten, beispielsweise auch in der Nähe oder sogar in Produktionsumgebungen oder zu Zeiten, etwa zu Tageszeiten, an welchen mit Schwingungen zu rechnen ist.

Damit können auch derartige hochpräzise Messinstrumente wie etwa ein Elektronenmikroskop oder ein Transmissions-Elektronenmikroskop wesentlich flexibler eingesetzt werden.

### Bezugszeichenliste

- 1: Magnetaktor
- 2: Magnetträger
- 3a, 3b: Magnet
- 4a, 4b: Magnet
- 5a, 5b: Schenkel
- 6: Platte
- 7: Spulenträger
- 8: Spule
- 9: magnetische Abschirmung
- 10: Seitenwand der magnetischen Abschirmung
- 11: Rückwand der magnetischen Abschirmung
- 12: Öffnung der magnetischen Abschirmung
- 13: Schwingungsisolationssystem
- 14: Platte
- 15: Schwingungsisolator
- 16: Sensor (Last)
- 17: Sensor (Boden)
- 18: Controller
- 19: Unterseite
- 20: Oberseite
- 21: Basisteil
- 22: Oberteil
- 23: Seitenteil

- 60: Magnetfeldsensor
- 61: Magnetaktor
- 62: Grundplatte

- 70: Magnetaktor
- 71: Träger
- 72: Magnet
- 73: Abschirmung

- 80: Magnetaktor
- 83: Abschirmung

- 90: Magnetaktor
- 91: Magnet
- 92: Windungsanordnung
- 93: Spulenträger

- 100: Magnetaktor
- 101: Magnet
- 102: Windungsanordnung
- 103: Spulenträger
- 104: seitliche Abschirmung
- 112: Öffnung

## Patentansprüche

1. Magnetaktor (1) für ein Schwingungsisolationssystem umfassend einen Magnetträger (2) mit sich gegenüberliegenden Magneten (3a, 3b, 4a, 4b), einen zwischen den Magneten (3a, 3b) angeordneten Spulenträger (7) mit zumindest einer Spule (8), wobei der Magnetaktor (1) eine magnetische Abschirmung (9) umfasst, **dadurch gekennzeichnet, dass** die magnetische Abschirmung (9) eine Öffnung (12) umfasst, aus welcher der Spulenträger (7) herausragt, und wobei der Magnetaktor (1) ferner zumindest zwei sich gegenüberliegende Magnetpaare (3a, 3b, 4a, 4b) umfasst, zwischen den die Windungen der Spule (8) verlaufen.

2. Magnetaktor (1) nach dem vorstehenden Anspruch, **dadurch gekennzeichnet, dass** die magnetische Abschirmung (9) aus einem Material mit einer Permeabilitätszahl µᵣ von über 1000, vorzugsweise über 10.000 und besonders bevorzugt über 50.000, insbesondere aus einem Mu-Metall, besteht.

3. Magnetaktor (1) nach einem der vorstehenden Ansprüche 1 oder 2, **dadurch gekennzeichnet, dass** die magnetische Abschirmung (9) den Magnetträger (1) umgibt oder dass der Magnetträger (1) einen Teil der magnetischen Abschirmung (9) bildet.

4. Magnetaktor (1) nach einem der vorstehenden Ansprüche 1 bis 3, **dadurch gekennzeichnet, dass** die Wände (10, 11) der magnetischen Abschirmung eine Dicke von 0,1 bis 10 mm, vorzugsweise von 0,2 bis 1 mm aufweisen.

5. Magnetaktor (1) nach einem der vorstehenden Ansprüche 1 bis 4, **dadurch gekennzeichnet, dass** die Pole der sich gegenüberliegen Magneten (3a, 3b, 4a, 4b) sich gegenüberliegen.

6. Magnetaktor (1) nach einem der vorstehenden Ansprüche 1 bis 5 **dadurch gekennzeichnet, dass** der Magnetträger (2) U-förmig ausgebildet ist.

7. Schwingungsisolationssystem (13), umfassend eine schwingungsisoliert gelagerte Last, wobei das Schwingungsisolationssystem (13) zumindest einen über einen Controller (18) angesteuerten Magnetaktor (1) umfasst, welcher an der schwingungsisoliert gelagerten Last angreift und Gegenkräfte zur Reduktion von Schwingungen erzeugt, wobei der Magnetaktor (1) ausgebildet ist nach einem der vorstehenden Ansprüche.

8. Schwingungsisolationssystem (13) nach dem vorstehenden Anspruch 7, **dadurch gekennzeichnet, dass** die magnetische Abschirmung (9) aus einem Mu-Metall besteht.

9. Schwingungsisolationssystem (13) nach einem der vorstehenden Ansprüche 7 oder 8, **dadurch gekennzeichnet, dass** die magnetische Abschirmung (9) als Gehäuse mit einer Öffnung in einer Wand ausgebildet ist, aus welcher ein Arm des Magnetaktors (1), insbesondere der Spulenträger (7), herausragt.

10. Schwingungsisolationssystem (13) nach einem der vorstehenden Ansprüche 7 bis 9, **dadurch gekennzeichnet, dass** der Magnetaktor (1) in einem Schwingungsisolator (15) integriert ist.

11. Schwingungsisolationssystem (13) nach einem der vorstehenden Ansprüche 7 bis 10, **dadurch gekennzeichnet, dass** das Schwingungsisolationssystem (13) zumindest zwei Magnetaktoren (1) zum Erzeugen von Kompensationssignalen in zumindest zwei unterschiedlichen Raumrichtungen umfasst.

12. Schwingungsisolationssystem (13) nach einem der vorstehenden Ansprüche 7 bis 11, umfassend eine auf Schwingungisolatoren (15) gelagerte Platte (14) zur Aufnahme eines schwingungsisoliert zu lagerndes Gerätes, wobei die Schwingungsisolatoren (15) zumindest einen des zumindest einen Magnetaktors (1) umfassen, wobei das in der Mitte der Platte (14) von den Magnetaktoren (1) verursachte Magnetfeld im Betrieb in einem Abstand von weniger als 70 cm, weniger als 50 cm, bevorzugt weniger als 45 cm und besonders bevorzugt von weniger als 40 cm von zumindest einem Schwingungsisolator (15), insbesondere einem Magnetaktor, unter 15 nT, bevorzugt unter 10 nT und besonders bevorzugt unter 9 nT liegt.

13. Schwingungsisolationssystem (13) nach einem der vorstehenden Ansprüche 7 bis 12, **dadurch gekennzeichnet, dass**
der Abstand zwischen benachbarten Magnetpaaren (3a, 4a, 3b, 4b) und/oder zwischen benachbarten Windungsanordnungen in einem Bereich zwischen 1 und 60 mm, bevorzugt zwischen 2 und 20 mm liegt.

14. Hochpräzise, abbildende optische Vorrichtung, insbesondere Mikroskop, Elektronenmikroskop oder Transmissions-Elektronenmikroskop, umfassend ein Schwingungsisolationssystem (13) mit zumindest einem Schwingungsisolator, wobei das Schwingungsisolationssystem (13) ausgebildet ist nach einem der vorstehenden Ansprüche 7 bis 13.

15. Hochpräzise, abbildende optische Vorrichtung nach dem vorstehenden Anspruch 14, wobei zumindest ein Schwingungsisolator (15) einen Magnetaktor (1) umfasst, besonders bevorzugt jeder der Schwingungsisolatoren (15) des Schwingungsisolationssystems (13), und wobei im Betrieb vorzugsweise das in der Mitte der Platte von den Magnetaktoren verursachte Magnetfeld in einem Abstand von weniger als 70 cm, weniger als 50 cm, bevorzugt weniger als 45 cm und besonders bevorzugt von weniger als 40 cm von zumindest einem Schwingungsisolator, insbesondere einem Magnetaktor, unter 15 nT, bevorzugt unter 10 nT und besonders bevorzugt unter 9 nT liegt.

## Claims

1. Magnetic actuator (1) for a vibration isolation system comprising a magnet carrier (2) with magnets (3a, 3b, 4a, 4b opposite each other, a coil carrier (7) with at least one coil (8) arranged between the magnets (3a, 3b, whereby the magnetic actuator (1) includes a magnetic shield (9),
**characterized in that**
the magnetic shield (9)includes an opening (12) from which the coil carrier (7) protrudes, and whereby the magnetic actuator (1) also comprises at least two pairs of magnets (3a, 3b, 4a, 4b) opposite each other, between which the windings of the coil (8) run.

2. Magnetic actuator (1) according to the above claim **characterized in that** the magnetic shield (9) consists of a material with a relative permeability µᵣ greater than 1000, preferably greater than 10.000 and with a particular preference for more than 50.000, made in particular from a mu-metal.

3. Magnetic actuator (1) according to one of the above claims 1 or 2, **characterized in that** the magnetic shield (9) surrounds the magnet carrier (1) or **in that** the magnet carrier (1) forms a part of the magnetic shield (9).

4. Magnetic actuator according to one of the above claims 1 to 3, **characterized in that** the walls (10, 11) of the magnetic shield have a thickness from 0,1 to 10 mm, preferably from 0,2 to 1 mm.

5. Magnetic actuator according to one of the above claims 1 to 4, **characterized in that** the poles of the magnets (3a, 3b, 4a, 4b) opposite each other are also positioned opposite each other.

6. Magnetic actuator according to one of the above claims 1 to 5, **characterized in that** the magnet carrier (2) takes the form of a U.

7. Vibration isolation system (13) comprising a load which is mounted such that it is isolated from vibrations, whereby the vibration isolation system (13) comprises at least one magnetic actuator (1) which is activated by a controller (18) which engages with the load mounted in such a way that it is isolated from vibrations and generates opposing forces to reduce vibrations, wherein the magnetic actuator (1) is set up according to one of the above claims.

8. Vibration isolation system (13) according to the above claim 7, **characterized in that** the magnetic shield (9) consists of a mu-metal.

9. Vibration isolation system (13) according to the above claims 7 or 8, **characterized in that** magnetic shield (9) takes the form of a case with an opening in one wall, out of which an arm of the magnetic actuator (1), in particular a coil carrier (7), protrudes.

10. Vibration isolation system (13) according to one of the above claims 7 to 9, **characterized in that** the magnetic actuator (1) is integrated into a vibration isolator.

11. Vibration isolation system (13) according to one of the above claims 7 to 10, **characterized in that** the vibration isolation system (13) comprises at least two magnetic actuators (1) to create compensation signals in at least two different spatial directions.

12. Vibration isolation system (13) according to one of the above claims 7 to 11, comprising a plate (14) mounted on vibration isolators (15) on which a device which is to be supported and isolated from vibrations is placed, whereby the vibration isolators (15) comprise at least one magnetic actuator (1) whereby , during operation, the magnetic field generated in the middle of the plate (14) by the magnetic actuators (1) is less than 15 nT, preferably less than 10 nT and particularly preferably less than 9 nT, at a distance of less than 70 cm or less than 50 cm, preferably less than 45 cm, and particularly preferably less than 40 cm from at least one vibration isolator (15), particularly magnetic actuators.

13. Vibration isolation system (13) according to one of the above claims 7 to 12, **characterized in that** the distance between neighboring pairs of magnets (3a, 3b, 4a, 4b) and/or between neighboring arrangements of windings is between 1 and 60 mm, preferably between 2 and 20 mm.

14. Ultra-precise optical imaging device, in particular a microscope, an electron microscope or a transmission electron microscope comprising a vibration isolation system (13) with at least one vibration isolator, wherein the vibration isolation system (13) is set up according to one of the above claims 1 to 13.

15. Ultra-precise optical imaging device according to the above claim 14, whereby at least one vibration isolator (15) comprises a magnetic actuator (1), and particularly preferred, each of the vibration isolators (15) of the vibration isolation system (13), and whereby, during operation, the magnetic field generated in the middle of the plate by the magnetic actuators is less than 15 nT, preferably less than 10 nT and particularly preferably less than 9 nT, at a distance of less than 70 cm or less than 50 cm, preferably less than 45 cm, and particularly preferably less than 40 cm from at least one vibration isolator, particularly magnetic actuators.

## Revendications

1. Actionneur magnétique (1) pour un système d'isolation contre les vibrations comprenant un support magnétique (2) comportant des aimants (3a, 3b, 4a, 4b) opposés, un support de bobine (7) disposé entre les aimants (3a, 3b) comportant au moins une bobine (8), dans lequel l'actionneur magnétique (1) comprend un blindage magnétique (9), **caractérisé en ce que** le blindage magnétique (9) comprend une ouverture (12), de laquelle dépasse le support de bobine (7), et dans lequel l'actionneur magnétique (1) comprend en outre au moins deux paires d'aimants (3a, 3b, 4a, 4b) opposés entre lesquels passent les enroulements de la bobine (8).

2. Actionneur magnétique (1) selon la revendication précédente, **caractérisé en ce que** le blindage magnétique (9) est constitué d'une matière présentant une perméabilité µᵣ supérieure à 1000, de préférence supérieure à 10 000 et de manière particulièrement préférée supérieure à 50 000, en particulier de mumétal.

3. Actionneur magnétique (1) selon l'une quelconque des revendications 1 ou 2 précédentes, **caractérisé en ce que** le blindage magnétique (9) entoure le support magnétique (1) ou **en ce que** le support magnétique (1) forme une partie du blindage magnétique (9).

4. Actionneur magnétique (1) selon l'une quelconque des revendications 1 à 3 précédentes, **caractérisé en ce que** les parois (10, 11) du blindage magnétique présentent une épaisseur allant de 0,1 et 10 mm, de préférence de 0,2 à 1 mm.

5. Actionneur magnétique (1) selon l'une quelconque des revendications 1 à 4 précédentes, **caractérisé en ce que** les pôles des aimants (3a, 3b, 4a, 4b) opposés sont opposés l'un à l'autre.

6. Actionneur magnétique (1) selon l'une quelconque des revendications 1 à 5 précédentes, **caractérisé en ce que** le support magnétique (2) est en forme de U.

7. Système d'isolation contre les vibrations (13) comprenant une charge montée isolée contre les vibrations, le système d'isolation contre les vibrations (13) comprenant au moins un actionneur magnétique (1) commandé par un dispositif de commande (18), lequel agit sur la charge montée isolée contre les vibrations et génère des forces antagonistes pour réduire les vibrations, dans lequel l'actionneur magnétique (1) est conçu selon l'une quelconque des revendications précédentes.

8. Système d'isolation contre les vibrations (13) selon la revendication 7 précédente, **caractérisé en ce que** le blindage magnétique (9) est constitué d'un mumétal.

9. Système d'isolation contre les vibrations (13) selon l'une quelconque des revendications 7 ou 8 précédentes, **caractérisé en ce que** le blindage magnétique (9) est conçu sous la forme d'un boîtier comportant une ouverture dans une paroi de laquelle dépasse un bras de l'actionneur magnétique (1), en particulier un support de bobine (7).

10. Système d'isolation contre les vibrations (13) selon l'une quelconque des revendications 7 à 9 précédentes, **caractérisé en ce que** l'actionneur magnétique (1) est intégré dans un isolateur contre les vibrations (15).

11. Système d'isolation contre les vibrations (13) selon l'une quelconque des revendications 7 à 10 précédentes, **caractérisé en ce que** le système d'isolation contre les vibrations (13) comprend au moins deux actionneurs magnétiques (1) pour générer des signaux de compensation dans au moins deux directions spatiales différentes.

12. Système d'isolation contre les vibrations (13) selon l'une quelconque des revendications 7 à 11 précédentes, comprenant une plaque (14) montée sur des isolateurs contre les vibrations (15) pour recevoir un appareil destiné à être monté de manière isolée contre les vibrations, dans lequel les isolateurs contre les vibrations (15) comprennent au moins un parmi le ou les actionneurs magnétiques (1), dans lequel le champ magnétique produit au centre de la plaque (14) par les actionneurs magnétiques (1), en service, à une distance inférieure à 70 cm, inférieure à 50 cm, de préférence inférieure à 45 cm et de manière particulièrement préférée inférieure à 40 cm d'au moins un isolateur contre les vibrations (15), en particulier un actionneur magnétique, est inférieur à 15 nT, de préférence inférieur à 10 nT et de manière particulièrement préférée inférieur à 9 nT.

13. Système d'isolation contre les vibrations (13) selon l'une quelconque des revendications 7 à 12 précédentes, **caractérisé en ce que**
la distance entre les paires d'aimants (3a, 4a, 3b, 4b) adjacents et/ou entre les ensembles à enroulement adjacents se situe dans une plage comprise entre 1 et 60 mm, de préférence entre 2 et 20 mm.

14. Dispositif d'imagerie optique de haute précision, en particulier microscope, microscope électronique ou microscope électronique à transmission, comprenant un système d'isolation contre les vibrations (13) comportant au moins un isolateur contre les vibrations, dans lequel le système d'isolation contre les vibrations (13) est conçu selon l'une quelconque des revendications 7 à 13 précédentes.

15. Dispositif d'imagerie optique de haute précision selon la revendication 14 précédente, dans lequel au moins un isolateur contre les vibrations (15) comprend un actionneur magnétique (1), de manière particulièrement préférée chacun des isolateurs contre les vibrations (15) du système d'isolation contre les vibrations (13), et dans lequel, en service, le champ magnétique produit au centre de la plaque par les actionneurs magnétiques, à une distance inférieure à 70 cm, inférieure à 50 cm, de préférence inférieure à 45 cm et de manière particulièrement préférée inférieure à 40 cm d'au moins un isolateur contre les vibrations, en particulier un actionneur magnétique, est inférieur à 15 nT, de préférence inférieur à 10 nT et de manière particulièrement préférée inférieur à 9 nT.
